Europäisches Patentamt

European Patent Office

Office européen des brevets

(19)

(11) Veröffentlichungsnummer: **0 013 279**
**A1**

(12) **EUROPÄISCHE PATENTANMELDUNG**

(21) Anmeldenummer: **78101768.6**

(22) Anmeldetag: **19.12.78**

(51) Int. Cl.³: **H 03 K 17/00**
**H 01 H 36/00**

(43) Veröffentlichungstag der Anmeldung:
**23.07.80 Patentblatt 80/15**

(84) Benannte Vertragsstaaten:
**BE CH DE FR GB LU NL SE**

(71) Anmelder: **Ballmer Technik KG**
**Postfach 939**
**CH-4002 Basel(CH)**

(72) Erfinder: **Pretzsch, Siegfried**
**Dürerstrasse 21a**
**D-5657 Haan/Rhld(DE)**

(74) Vertreter: **Hemmerich, Friedrich Werner et al,**
**Patentanwälte**
**HEMMERICH-MÜLLER-GROSSE-POLLMEIER Berliner**
**Allee 41**
**D-4000 Düsseldorf 1(DE)**

(54) Berührungsschalteranordnung.

(57) Anordnung eines Berührungsschalters mit zur Schaltauslösung dienenden Positions-Druckfeldern (1), die sich auf der Vorderseite einer Glasscheibe (2) in Form von aufgedampften Metallegierungsschichten befinden, und mit Kontaktierungsflächen (3), die den Positions-Druckfeldern gegenüberliegend an der Rückseite der Glasscheibe angeordnet und mit einer gedruckten Schaltung leitend verbindbar sind, wobei die Kontaktierungsflächen auf der Rückseite der Tragplatte (4) der gedruckten Schaltung liegen und die Tragplatte mit dieser Seite auf die Rückseite der Glasplatte auflegbar und andrückbar ist.

Fig. 2

EP 0 013 279 A1

SIEGFRIED PRETZSCH, 5657 Haan / Rhld.

Berührungsschalteranordnung

Die Erfindung bezieht sich auf eine Berührungsschalteranordnung, bestehend aus innerhalb von Positions-Druckfeldern auf die Vorderseite einer Glasscheibe aufgedampften Metallegierungen und diesen gegenüberliegend auf der Rückseite der Scheibe befindlichen Kontaktierungsflächen, die mit Schaltelementen der Tragplatte einer gedruckten Schaltung leitend verbindbar sind.

Bei bekannten Berührungsschalteranordnungen dieser Art ist die Tragplatte der gedruckten Schaltung mit Abstand von der Rückseite der Glasscheibe ortsfest in einer Halterung angebracht und die leitende Verbindung zwischen der Tragplatte und den auf dieser befindlichen Schaltelementen wird durch auf der Platte befestigte Kontaktfedern bewirkt, die den Abstand zwischen beiden Platten überbrücken und auf den Kontaktierungsflächen der Glasscheibenrückseite aufliegen.

Neben der Schwierigkeit, die das Anbringen der notwendigen zahlreichen Federn auf der Tragplatte bereitet und dem Platzbedarf der Befestigung, der für Leiterbahnen und Schaltelemente der Tragplatte verloren geht, bringen diese bekannten Schalteranordnungen noch den wesentlichen Nachteil des großen Herstellungsaufwandes mit sich, der für das Anbringen der Kontaktierungsflächen auf der Rückseite der Glasscheibe notwendig ist. Dieser Aufwand ist besonders groß, wenn es sich um hitzebeständige Glas- oder Keramikplatten handelt, wie sie beispielsweise als Heiz- und Kochplatten verwendet werden. Der große Herstellungsaufwand erfordert dabei aus wirtschaftlichen Gründen auch entsprechend große Stückzahlen ein- und

- E 2 -

- 3 -

derselben Anordnung der Kontaktierungsflächen auf der Scheibe.

Der Erfindung liegt die Aufgabe zugrunde, die erwähnten Schwierigkeiten zu vermeiden und die Nachteile zu beseitigen. Diese Aufgabe wird dadurch gelöst, daß die Kontaktierungsflächen nicht auf der Rückseite der Glas- bzw. Keramikscheibe sondern auf der Rückseite der Tragplatte der gedruckten Schaltung angeordnet sind, und die Tragplatte mit dieser Rückseite auf die Rückseite der Glasplatte auflag- und mittels federnder Andruckelemente gegen diese andrückbar ist.

Die Kontaktierungsflächen lassen sich auf diese Weise mit erprobten und bekannten Techniken auf die Tragplatte der gedruckten Schaltung selbst aufbringen und die Glasplatte bedarf nur der Aufbringung der Positionsdruckfelder mit der aufgedampften Metallegierung auf ihrer Vorderseite. Die auf die Tragplatte der gedruckten Schaltung aufgebrachten Kontaktierungsflächen treten durch das Auflegen und Andrücken der Tragplatte auf die Unterseite der Glasscheibe in exakt gleicher Position an die Stelle der bisher mit erheblichem Herstellungsaufwand auf die Rückseite der Glasscheibe aufgebrachten Kontaktierungsflächen. Anders als diese können sie aber durch Wegnehmen der Tragplatte jederzeit von dort wieder entfernt und durch andere ersetzt werden.

Die Andruckelemente für die Tragplatte können aus Federstiften bestehen, die die Tragplatte in nahe bei den Kontaktierungsflächen gelegenen, nicht leitenden, Bereichen der Tragplattenfläche unterfaßt. Zur Vermeidung des Andrückens von Lötpunkten oder Leiterbahnen, die sich neben den Kontaktierungsflächen ebenfalls auf der Rückseite der Tragplatte befinden, an die Unterseite der Glasplatte, können, wie die Erfindung weiter vorsieht, die Kontaktierungsflächen auf Abstandsplatten aus

- D 3 -

leitfähigem oder nichtleitfähigem Werkstoff aufgebracht sein, deren Stärke grösser ist als die Höhe der Lötpunkte bzw. Leiterbahnen.

5   Schließlich besteht noch erfindungsgemäß die Möglichkeit, Tragplatte und Glasscheibe im aufeinandergelegten Zustand miteinander zu verkleben.

Die Erfindung wird anhand des in der Zeichnung dargestellten Ausführungsbeispiels näher erläutert. In der Zeichnung zeigen:

Fig. 1    die Schalteranordnung, auseinandergezogen, in perspektivischer Darstellung,

Fig. 2    die Schalteranordnung in Betriebsstellung im Schnitt, von der Seite gesehen, und

Fig. 3    einen Schnitt durch die Tragplatte im vergrösserten Maßstab.

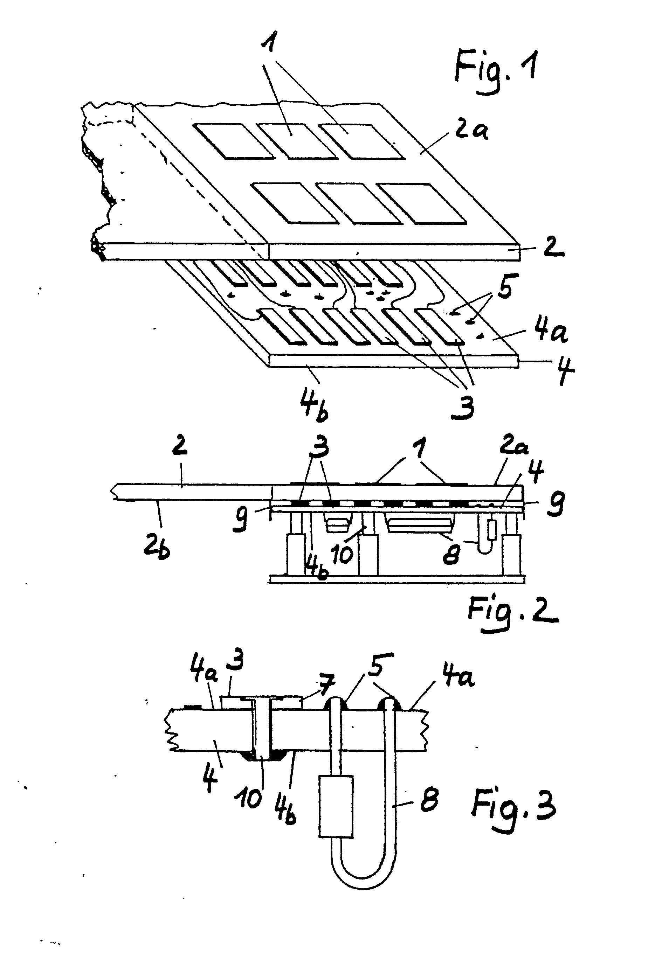

Wie aus Fig. 1 ersichtlich, sind die Positionierungsdruckfelder 1 auf der Vorderseite 2a der Glas- oder Keramikplatte 2 angeordnet. Die Kontaktierungsflächen 3 befinden sich auf der Rückseite 4a der Tragplatte 4 der gedruckten Schaltung. Die Leiterbahnen und die Schaltelemente der gedruckten Schaltung sind auf der in Fig. 1 nicht erkennbaren Vorderseite 4b der Tragplatte angeordnet und nur die Lötpunkte 5 dieser Schaltung befinden sich zwischen den Kontaktierungsflächen 3 auf der Rückseite 4a der Tragplatte 4.

Aus Fig. 2 geht hervor, wie die Tragplatte 4, durch Leitscheiben 9 gegen seitliche Verschiebung gesichert, mittels der Federstifte 10, die die Vorderseite 4b in den nichtleitenden Bereichen zwischen den Schaltelementen 8 unterfassen, gegen die Unterseite 2b der Glasplatte 2 gedrückt wird, wobei die Kontaktierungsflächen 3 an dieser Unterseite anliegen.

Aus Fig. 3 geht hervor, daß die Kontaktierungsflächen 3 dabei auf Abstandsplatten 7 aufgebracht sind, die hier mittels einer Hohlniet 10 auf der Tragplatte 4 befestigt wurden. Die Stärke der Abstandsplatte 7 ist grösser als die Höhe der neben dieser angedeuteten Lötpunkte 5 für die Schaltelemente 8.

SIEGFRIED PRETZSCH, 5657 Haan / Rhld.

Patentansprüche

1. Berührungsschalteranordnung, bestehend aus innerhalb von Positions-Druckfeldern auf die Vorderseite einer Glasscheibe aufgedampften Metallegierungen und, diesen gegenüberliegend, auf der Rückseite der Scheibe befindlichen Kontaktierungsflächen, die mit Schaltelementen der Tragplatte einer gedruckten Schaltung leitend verbindbar sind, d a d u r c h   g e k e n n z e i c h n e t , daß die Kontaktierungsflächen (3) auf der Rückseite (4a) der Tragplatte (4) der gedruckten Schaltung angeordnet sind und die Tragplatte (4) mit dieser Rückseite (4a) auf die Rückseite (2b) der Glasplatte (2) auflegbar und mittels Andruckelementen (10) gegen diese andrückbar ist.

- 2 -

2. Berührungsschalteranordnung nach Anspruch 1,
   d a d u r c h   g e k e n n z e i c h n e t,
   daß die Andruckelemente für die Tragplatte (4) aus Federstiften (10) bestehen, die die Tragplatte (4) in nahe bei
   den Kontaktierungsflächen (3) gelegenen, nicht leitenden,
   Bereichen der Tragplatten-Vorderseite (4b) unterfassen.

3. Berührungsschalteranordnung nach Anspruch 2,
   d a d u r c h   g e k e n n z e i c h n e t,
   daß die Kontaktierungsflächen (3) auf Abstandsplatten (7)
   aus leitfähigem oder nichtleitfähigem Werkstoff aufgebracht
   sind.

4. Berührungsschalteranordnung nach den Ansprüchen 1 und/oder 3
   d a d u r c h   g e k e n n z e i c h n e t,
   daß die Glasplatte (2) und die Tragplatte (4) mit ihren
   Rückseiten (2b und 4a) aufeinanderliegend verklebt sind.

- Ende -

Fig. 1

Fig. 2

Fig. 3

JC13279

Europäisches
Patentamt

EUROPÄISCHER RECH~~~~ ~~~~BERICHT

Nummer der Anmeldung

EP 78 101 768.6

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | <u>DE - B - 2 318 211</u> (NORDDEUTSCHE MENDE RUNDFUNK KG)<br>* ganzes Dokument *<br><br>-- | 1 |
| A | <u>DE - A - 2 731 556</u> (GENERAL ELECTRIC CO.)<br>* Fig. 12 *<br><br>-- | 1 |
| A | <u>FR - A - 2 267 619</u> (BASSANI S.P.A.)<br>* ganzes Dokument *<br><br>-- | 1 |
| A | <u>US - A - 4 056 699</u> (ESSEX INTERNATIO-NAL INC.)<br>* Spalte 3, Zeilen 26 bis 38; Fig. 1 bis 3; Fig. 6 *<br><br>---- | 1 |

**KLASSIFIKATION DER ANMELDUNG (Int.Cl.²)**

H 03 K 17/00
H 01 H 36/00

**RECHERCHIERTE SACHGEBIETE (Int. Cl.²)**

G 06 F 3/02
H 01 H 13/70
H 01 H 35/00
H 01 H 36/00
H 03 J 5/00
H 03 K 17/00
H 05 K 1/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 30-07-1979 | ARENDT |

EPA form 1503.1 06.78